Europäisches Patentamt

European Patent Office

Office européen des brevets

(11) Veröffentlichungsnummer: **0 226 754 B1**

(12) **EUROPÄISCHE PATENTSCHRIFT**

(45) Veröffentlichungstag der Patentschrift: **18.12.91**

(51) Int. Cl.⁵: **H04J 3/04**

(21) Anmeldenummer: **86114819.5**

(22) Anmeldetag: **24.10.86**

(54) Schaltungsanordnung zur Erzeugung mehrerer Takte.

(30) Priorität: 24.12.85 DE 3546131
24.12.85 DE 3546132

(43) Veröffentlichungstag der Anmeldung:
01.07.87 Patentblatt 87/27

(45) Bekanntmachung des Hinweises auf die
Patenterteilung:
18.12.91 Patentblatt 91/51

(84) Benannte Vertragsstaaten:
FR GB IT NL

(56) Entgegenhaltungen:
US-A- 4 353 031

TOUTE L'ELECTRONIQUE, Nr. 502, März 1985,
Seite 91, Paris, FR; "4 sorties déphasées à
90 degrés"

IEEE ELECTRON DEVICE LETTERS, Band
EDL-5, Nr. 9, September 1984, Seiten 371-373,
IEEE, New York, US; R.K. JAIN et al.: "A new
technique for the measurement of speeds of
Gigahertz digital IC's"

ELECTRONICS LETTERS, Band 20, Nr. 13, 21.
Juni 1984, Seiten 546-548, Hitchin, GB; H.
REIN et al.: "Integrated bipolar 4:1 timedivision multiplexer for bit rates up to 3
Gbit/s"

ELECTRONICS LETTERS, Band 20, Nr. 11, 24.
Mai 1984, Seiten 471,472, Hitchin, GB; D.
CLAWIN et al.: "Monolithic multigigabit/s silicon decision circuit for applications in fibreoptic communication systems"

IBM TECHNICAL DISCLOSURE BULLETIN,
Band 24, Nr. 4, September 1981, Seiten
2201,2202, New York, US; R.C. WONG: "JK
flip-flop"

ELEKTROTECHNIK, Heft 19, 6. Oktober 1971,
Seiten 49,50, Wurzburg, DE; G. HARMS:
"Grundlagen und Praxis digitaler Schaltkreise"

(73) Patentinhaber: ANT Nachrichtentechnik GmbH
Gerberstrasse 33
W-7150 Backnang(DE)

(72) Erfinder: Rein, Hans-Martin, Prof. Dr.
Ein Bäumchen 6
W-5810 Witten 3(DE)

## Beschreibung

Die Erfindung bezieht sich auf eine Schaltungsanordnung zur Erzeugung von vier um $\pi/2$ bzw. von n um $2\pi/n$ gegeneinander verschobenen Takten gemäß Oberbegriff des Patentanspruches 1 bzw. 4.

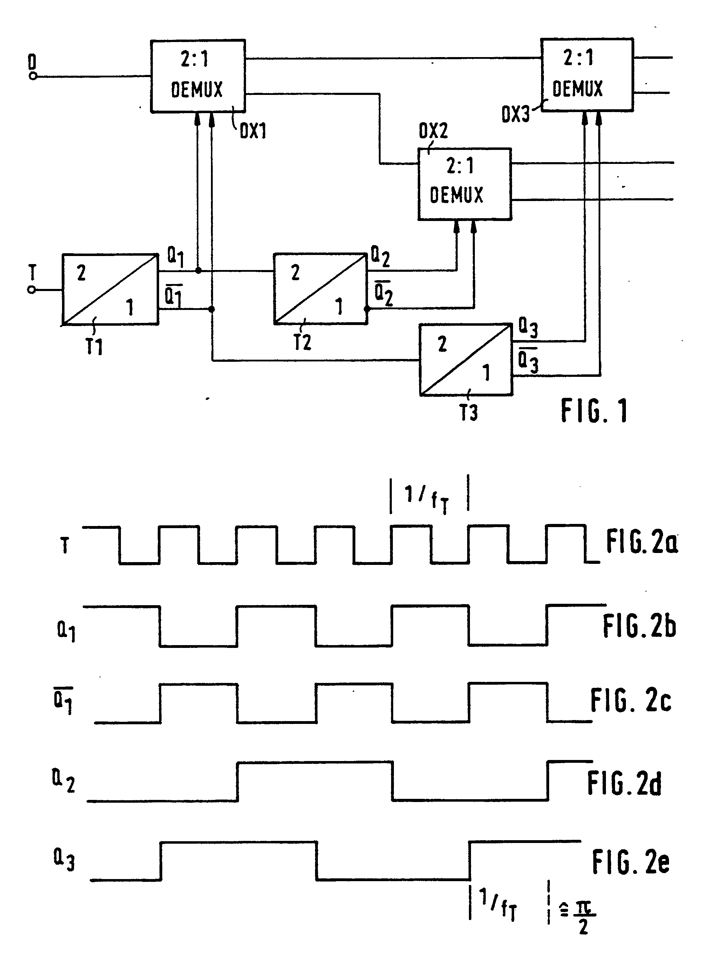

In der Nachrichtentechnik werden des öfteren zur Signalverarbeitung Takte benötigt, die zeitlich um $\pi/2$ gegeneinander versetzt sind. Solche Takte werden durch gleichzeitiges Teilen eines Taktsignales der doppelten Frequenz und des dazu komplementären Taktsignals erzeugt. Als Beispiel gilt die in Figur 1 angegebene Schaltungsanordnung für eine 2-stufigen 1:4-Demultiplexer für hohe Bitraten. Es sind die drei 2:1-Demultiplexer DX1 bis DX3 erkennbar, durch die das Datensignal D in die 4 Einzelsignale demultiplext wird. Die dazu erforderliche Taktversorgung erfolgt durch eine ebenfalls 2-stufige Flip-Flop-Anordnung F1 bis F3, in der das Taktsignal T des Eingangs-Datenmultiplex-Signals D jeweils frequenzmäßig halbiert wird. Die beiden Flip-Flops F2 und F3 - der 2. Stufe realisieren dabei das o.g. gleichzeitige Teilen eines Taktsignals Q1 mit der halben Eingangstaktrate T bzw. des komplementären Signals $\overline{Q1}$. Die Ausgangssignale Q2 und Q3 der Flip-Flops F2 und F3 der 2. Stufe bzw. die invertierten Ausgangssignale $\overline{Q2}$ und $\overline{Q3}$ sind die für die Demultiplexer der 2. Stufe benötigten um $\pi/2$ versetzten Taktsignale mit der Taktrate von 1/4 der Taktrate des eingangsseitigen Taktsignals T.
Die beiden Takt-Teiler-Flip-Flops T2 und T3 der 2. Stufe gemäß Fig. 1 müssen ebenso wie die 1. Teiler-Stufe bei Demultiplexern für Hochgeschwindigkeitsüberagung durch sehr schnelle Bauelemente realisiert sein, beispielsweise in ECL- oder E$^2$CL-Technik. Solche schnellen Bausteine sind erheblich teurer als Bausteine in Normal-Technik und erfordern einen wesentlich höheren Stromverbrauch von z.B. bis zu 200 mWatt.

Es ist erkennbar, daß die Anzahl der in einem Breitbandmultiplexer benötigten 2:1-Teilerstufen der Anzahl an Ästen und Zweigen in einem Stammbaum entspricht, d.h. daß in jeder i. Stufe $2^{i-1}$ 2:1-Teiler benötigt werden, die jeweils durch gleichzeitiges Teilen eines Taktsignals Q1 und eines dazu komplementären Taktsignals $\overline{Q1}$ weitere Taktsignale erzeugen.

Der Erfindung lag die Aufgabe zugrunde, eine Schaltungsanordnung der eingangs genannten Art anzugeben, die mit weniger Schaltungsaufwand auszukommen imstande ist.

Die Lösung dieser Aufgabe erfolgt durch die kennzeichnenden Merkmale gemäß Anspruch 1.

Die erfindungsgemäße Schaltungsanordnung weist die Vorteile auf, daß eines der schnellen, teuren Flip-Flops eingespart wird. Damit wird auch der Stromverbrauch wesentlich geringer. Beim Einsatz in den vorgenannten Demultiplexern ergeben sich die weiteren Vorteile, daß erstens für die 1. Teilerstufe trotz der doppelten Frequenz ein dynamischer Frequenzteiler (für die Flip-Flops der 2. Stufe werden jedoch statische Teiler benötigt) verwendet werden kann, wodurch die Verlustleistung ebenfalls gesenkt wird. Zweitens ist die Belastung der ersten Teilerstufe geringer. Drittens wird der ungünstige Einfluß von Parameterschwankungen zwischen den beiden Flip-Flops der 2. Stufe der Anordnung nach Fig. 1 vermieden.

In IEEE Electron Device Letters, Band EDL-5, Nr. 9, September 1984, Seiten 371-373 ist eine Schaltungsanordnung zur Feststellung der Durchlaufzeiten bzw. Grenzfrequenzen eines Flip-Flops beschrieben, wobei ein statischer Frequenzteiler aus einem rückgekoppelten Master-Slave-D-Flip-Flop verwendet wird. Um $\pi/2$ gegeneinander verschobene Takte können hier aber nicht zur Verfügung stehen.

Aus Toute l'Electronique, Nr. 502, März 1985, Seite 91 ist eine Schaltung bekannt geworden, welche zwar um $\pi/2$ verschobene Signale erzeugt, aber dazu zwei Master-Slave-D-Flip-Flops benötigt. Außerdem beaufschlagt die Schaltung den Ausgangstakt eines VCO direkt an den Takteingang beider Flip-Flops, wodurch der Eingangstakt nicht halbiert, sondern geviertelt wird, so daß die Ausgangssignale eine Frequenz von nur einem Viertel der Eingangstaktfrequenz aufweisen.

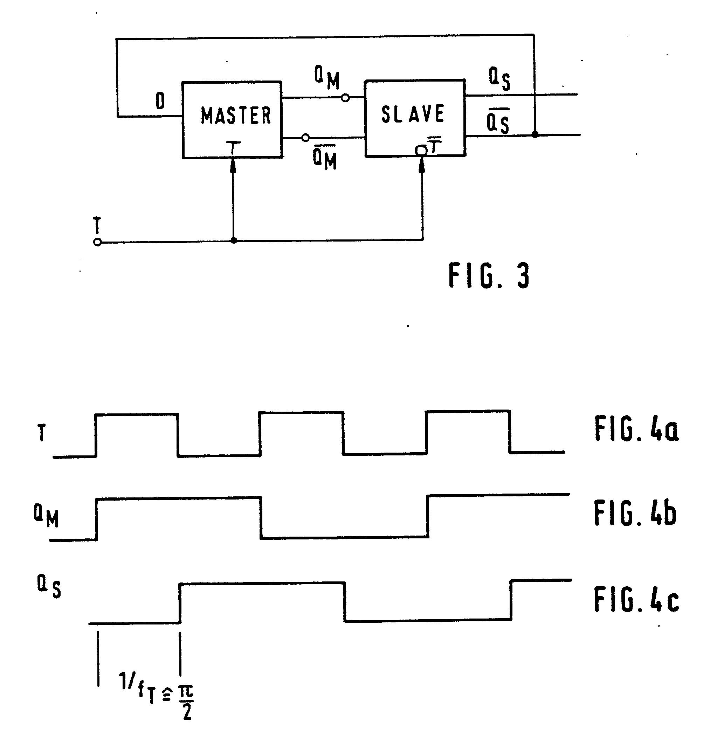

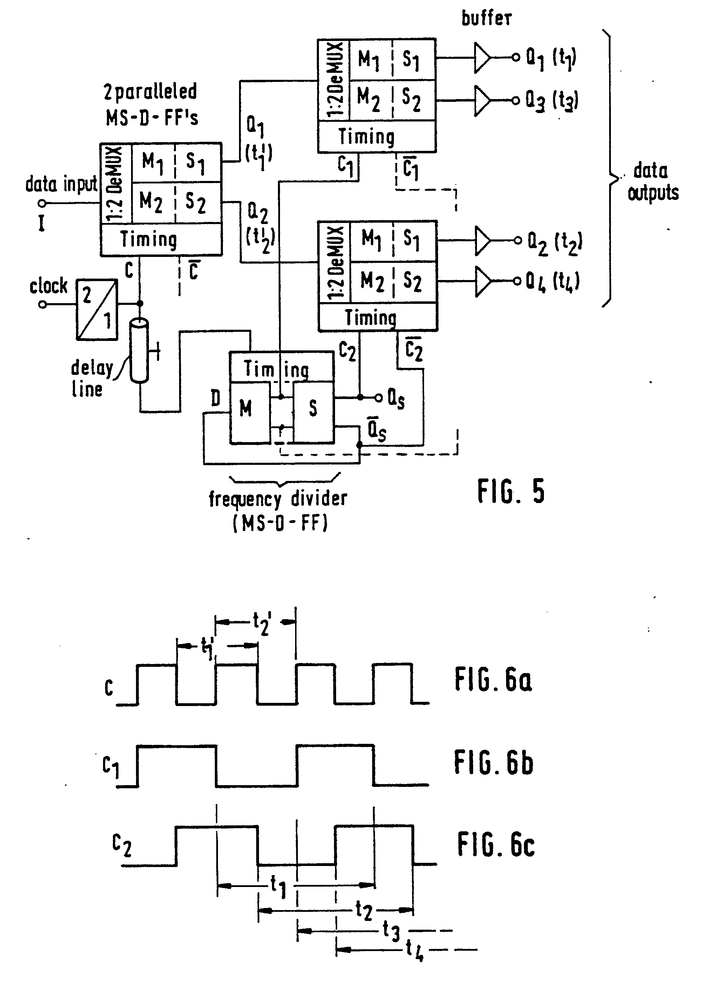

Es folgt die Beschreibung der Erfindung anhand der Figuren. Die Figur 3 zeigt ein Ausführungsbeispiel für die erfindungsgemäße Schaltungsanordnung, die Figuren 4a bis 4c je ein Impulsdiagramm mit über der Zeit aufgetragenen Signalen von Punkten der Anordnung nach Figur 3.

Schließlich zeigt die Figur 5 als Anwendungsbeispiel das Blockschaltbild eines 2-stufigen 1:4-Demultiplexers für hohe Bitraten, in dem die erfindungsgemäße Schaltungsanordnung eingesetzt ist.

In den Figuren 6a bis 6c sind verschiedene Taktsignale über der Zeit aufgetragen, die an entsprechenden Punkten der Schaltung nach Figur 5 anstehen.

In Figur 3 ist die Ringkaskadenschaltung zweier Flip-Flops erkennbar, wobei als Ausführungsbeispiel das 1. Flip-Flop ein Master- und das 2. Flip-Flop ein Slave-Teil eines Master-Slave-Flip-Flops ist. Der negierte Ausgang des Slave-Teils ist auf den D-Eingang des Master-Teils rückgekoppelt, das ganze Master-Slave-Flip-Flop wird mittels des Taktes T getaktet (der beim Slave-Teil auf den invertierenden Eingang $\overline{T}$ geführt ist).

In Figur 4a ist der Takt über der Zeit aufgetragen, in Figur 4b darunter der Ausgang $Q_M$ des Master-Teils und darunter in Figur 4c der Ausgang $Q_S$ des Slave-Teils. Wie man sieht, sind die beiden

letzteren Signale um $\pi/2$ gegeneinander versetzt und weisen die halbe Rate des Taktsignals T auf. In der Figur 5 ist das Blockschaltbild für einen 2-stufigen 1:4-Demultiplexer für hohe Bitraten gezeichnet, wobei das Eingangsdatensignal I in 2 Stufen über 3 parallelisierte Master-Slave-D-Flip-Flops MS-D-FF demultiplext wird und über Treiberstufen als Einzelsignale Q1 (t1) bis Q4 (t4) am Datenausgang ansteht.

Der frequenzhalbierte Takt C, der aus dem eingangsseitigen Takt Clock oder direkt aus dem Multiplex-Datensignal gewonnen wird, wird der Taktschaltung Timing der 1. Demultiplexer-Stufe und ihren beiden zwischenspeichernden Master-Slave-Flip-Flops M1S1 und M2S2 zugeführt. Der frequenzhalbierte Takt C wird über eine etwaige Laufzeitunterschiede ausgleichende Verzögerungsleitung Delay-Line ebenfalls der erfindungsgemäßen Anordnung eines Master-Slave-Flip-Flops MS zugeführt, dessen invertierter Ausgang $\overline{Q_S}$ auf den D-Eingang des Master-Teils rückgekoppelt ist. Die Ausgänge des Master-Teils M und des Slave-Teils S bieten die beiden ersten um $\pi/2$ versetzten Takte C1 und C2, und die invertierten Ausgänge die beiden letzten um $\pi/2$ versetzten Takte $\overline{C1}$ und $\overline{C2}$. Durch den ersten C1 und dritten Takt $\overline{C1}$ wird der eine 1:2-Demultiplexer Demux und das eine Master-Slave-Flip-Flop-Paar angesteuert, welche somit das erste Q1 (t1) und das dritte Einzelsignal Q3 (t3) liefern.

In entsprechender Weise wird der andere 1:2-Demultiplexer und das andere Master-Slave-Flip-Flop-Paar von dem zweiten C2 und vierten Takt $\overline{C2}$ angesteuert, wodurch das zweite Q2 (t2) und vierte Einzelsignal Q4 (t4) erzeugt werden. Zur Vereinfachung sind die komplementären Daten- und Taktleitungen z.T. nicht in die Figur gezeichnet. Die Figur 6a zeigt den frequenzhalbierten Takt C, während die Figuren 6b und 6c die nochmals frequenzhalbierten und um $\pi/2$ gegeneinander versetzten Takte C1 und C2 zeigen.

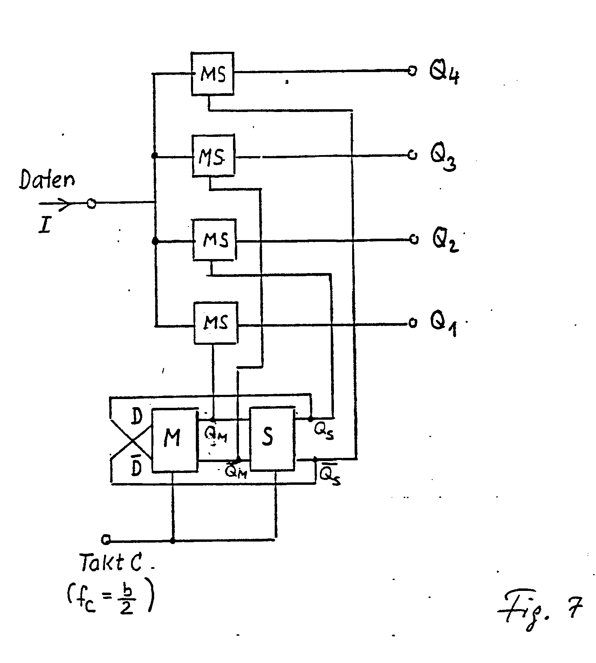

In Fig. 7 ist als weiteres Ausführungsbeispiel ein 1-stufiger 1:4-Demultiplexer dargestellt, der 4 eingangsseitig parallel geschaltete und mit dem empfangenen Multiplex-Datensignal beaufschlagten Master-Slave-Flip-Flop MS enthält, die von der erfindungsgemäßen Takterzeugungsanordnung mit jeweils um $\pi/2$ versetzten Takten versorgt werden. Diese Anordnung besteht aus einem MS-Flip-Flop, dessen Slave-Ausgang auf den invertierten Eingang und dessen invertierter Slave-Ausgang aus Symmetriegründen auf den Eingang des Master-Teils rückgekoppelt sind und das durch einen Takt C, dessen Frequenz $f_c$ der halben Bitrate b des Multiplex-Datensignals entspricht, getaktet wird.

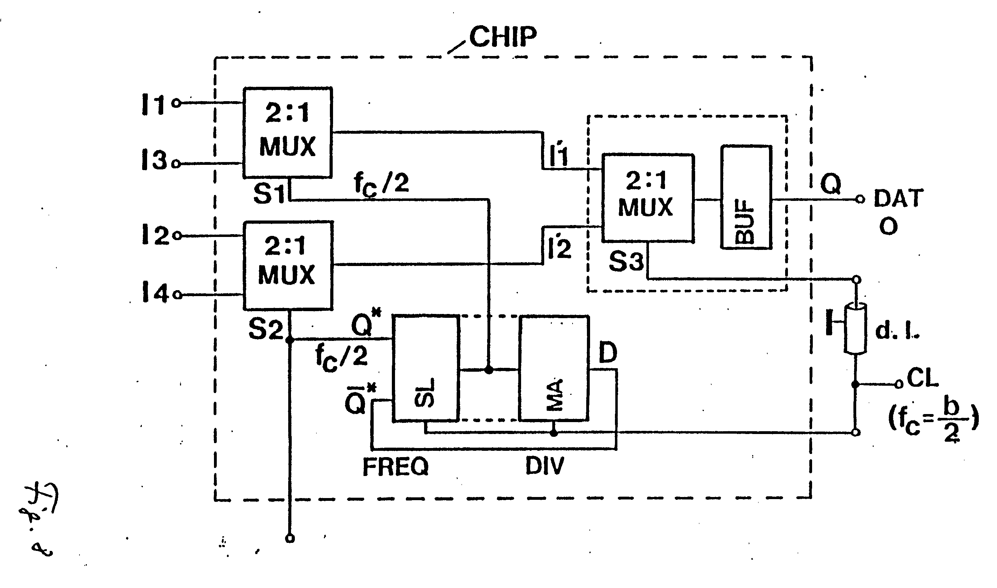

Selbstverständlich ist die erfindungsgemäße Anordnung auch in einem 4:1-Multiplexer anwendbar, wie er beispielsweise in Fig. 8 gezeigt ist. In dem 2-stufigen Multiplexer werden die 4 Einzelsignale I1 bis I4 durch 2 2:1-Mux zunächst zu 2 Signalen I'1 und I'2 und durch einen weiteren 2:1-Mux zum Multiplexsignal Q zusammengefaßt. Die erforderlichen 4 Takte werden von dem erfindungsgemäßen Master-Slave-Ring Frequency Divider geliefert, welche aus dem schnellen Systemtakt Clock der Frequenz $f_c = b/2$ die jeweils um $\pi/2$ versetzten Takte S1, S2 und die dazu invertierten Takte (nicht gezeichnet) der halben Frequenz $f_c/2$ liefert.

## Patentansprüche

1. Schaltungsanordnung zur Erzeugung von vier um $\pi/2$ gegeneinander verschobenen Takte der halben Frequenz, dadurch gekennzeichnet, daß ein einziges Master-Slave-Flip-Flop vorgesehen ist, dessen Master- und Slave-Teil zu einer Kaskade hintereinander geschaltet sind, die durch eine Rückkopplung zu einem Ring ergänzt ist, wobei eine der beiden Kopplungen, also entweder die Rückkopplung oder die kaskadische Kopplung, invertiert erfolgt, d.h. daß beispielsweise im ersten Fall der Eingang (D) des Masterteils mit dem invertierten Ausgang $(\overline{Q_S})$ des Slave-Teils und/oder der invertierte Eingang des Masterteils mit dem Ausgang des Slave-Teils verbunden sind, und wobei die andere Kopplung nicht invertiert erfolgt, d.h. daß der Ausgang $(Q_M)$ des Master-Teils mit dem Eingang des Slave-Teils und der invertierte Ausgang $(\overline{Q_M})$ des Master-Teils mit dem invertierten Eingang des Slave-Teils verbunden sind, und daß die Ausgänge $(Q_M, Q_S)$ bzw. die invertierten Ausgänge $(\overline{Q_M}, \overline{Q_S})$ der beiden Flip-Flop-Teile die um $\pi/2$ gegeneinander verschobenen Takte der halben Frequenz liefern.

2. Schaltungsanordnung nach Anspruch 1, gekennzeichnet durch die Anwendung in einem 1- oder 2-stufigen 1:4-Demultiplexer für hohe Bitraten.

3. Schaltungsanordnung nach Anspruch 1 oder 2, gekennzeichnet durch die Anwendung in einem 1- oder 2-stufigen 4:1-Multiplexer.

4. Schaltungsanordnung zur Erzeugung von n um $2\pi/n$ gegeneinander verschobenen Takten in einem digitalen Nachrichtenübertragungssystem, wobei Bitströme von der Anzahl der 2er-Potenz n mit der gleichen Bitrate auf der Senderseite mittels Breitband-Multiplexer im Zeitmultiplex zum Multiplex-Datensignal zusammengefaßt, übertragen und auf der Empfangsseite mittels Breitband-Demultiplexer wieder getrennt werden, wobei der Breitband-Multiplexer und der Breitband-Demultiplexer mit den n Takten gesteuert werden, die jeweils eine der Bitrate eines der n Bitströme entsprechenden Taktfrequenz aufweisen, wobei die Takterzeugung durch einen oder durch mehrere, stufenförmig angeordnete 2:1-Teiler erfolgt, dadurch gekennzeichnet, daß mindestens ein 2:1-Teiler durch ein einziges Master-Slave-Flip-Flop realisiert ist, dessen Master- und Slave-Teil zu einer Kaskade hintereinander geschaltet sind, die durch eine Rückkopplung zu einem Ring ergänzt ist, wobei eine der beiden Kopplungen, also entweder die Rückkopplung oder die kaskadische Kopplung, invertiert erfolgt, d.h. daß beispsielweise im ersten Fall der Eingang (D) des Masterteils mit dem invertierten Ausgang ($\overline{Q_S}$) des Slave-Teils und/oder der invertierte Eingang des Masterteils mit dem Ausgang des Slave-Teils verbunden sind, und wobei die andere Kopplung nicht invertiert erfolgt, d.h. daß der Ausgang ($Q_M$) des Master-Teils mit dem Eingang des Slave-Teils und der invertierte Ausgang ($\overline{Q_M}$) des Master-Teils mit dem invertierten Eingang des Slave-Teils verbunden sind, und

das die Ausgänge ($Q_M$, $Q_S$) bzw. die invertierten Ausgänge ($\overline{Q_M}$, $\overline{Q_S}$) der beiden Flip-Flop-Teile die um $2\pi/n$ gegeneinander verschobenen Takte (C1, $\overline{C1}$, C2, $\overline{C2}$) der halben Frequenz liefern.

5. Schaltungsanordnung nach einem der vorhergehenden Ansprüche, dadurch gekennzeichnet, daß das Master-Slave-Flip-Flop ein D-, $\overline{RS}$- oder JK-Flip-Flop ist.

**Claims**

1. Circuit arrangement for the production of four pulses at half the frequency and displaced through $\pi/2$ one relative to the other, characerised thereby, that a single master-slave flip-flop is provided, the master and slave parts of which are connected one behind the other into a cascade which is augmented by a feedback path into a loop, wherein one of both the couplings, thus either the feedback path or the cascade coupling, takes place in inverted manner, i.e. that for example in the first case, the input (D) of the master part is connected with the inverted output ($\overline{Q_S}$) of the slave part and/or the inverted input of the master part is connected with the output of the slave part, and wherein the other coupling takes place in non-inverted manner, i.e. that the output ($Q_M$) of the master part is connected with the input of the slave part and the inverted output ($\overline{Q_M}$) of the master part is connected with the inverted input of the slave part, and that the outputs ($Q_M$, $Q_S$) or the inverted outputs ($\overline{Q_M}$, $\overline{Q_S}$) of both the flip-flop parts supply the pulses at half the frequency and displaced through $\pi/2$ one relative to the other.

2. Circuit arrangement according to claim 1, characterised by the use in a single stage or a two-stage 1:4 demultiplexer for high bit rates.

3. Circuit arrangement according to claim 1 or 2, characterised by the use in a single stage or a two-stage 4:1 multiplexer.

4. Circuit arrangement for the production of n pulses displaced through $2\pi/n$ one relative to the other in a digital communication system, wherein bit flows of the number of the second power n are combined at the same bit rate at the transmission end into a multiplex data signal in time multiplex by means of wideband multiplexer, are transmitted and again separated at the reception end by means of wideband demultiplexer, wherein the wideband multiplexer and the wideband demultiplexer are controlled by the n pulses which each display a pulse frequency corresponding to the bit rate of one of the n bit flows, wherein the pulse generation takes place through one or more 2:1 dividers arranged in step shape, characterised thereby, that at least one 2:1 divider is realised by a single master-slave flip-flop, the master and slave parts of which are connected one behind the other into a cascade which is augmented by a feedback path into a loop, wherein one of both the couplings, thus either the feedback path or the cascade coupling, takes place in inverted manner, i.e. that for example in the first case, the input (D) of the master part is connected with the inverted output ($\overline{Q_S}$) of the slave part and/or the inverted input of the master part is connected with the output of the slave part, and wherein the other coupling takes place in non-inverted manner, i .e. that the output ($\overline{Q_M}$) of the master part is connected with the inverted input of the slave part and the inverted output ($Q_m$) of the master part is connected with the inverted input of the slave part, and that the outputs ($\overline{Q_M}$, $\overline{Q_S}$) or the inverted outputs ($Q_M$, QS) of both the flip-flop parts supply the pulses (C1, $\overline{C1}$, C2, $\overline{C2}$) at half the frequency and displaced through $2\pi/n$ one relative to the other.

5. Circuit arrangement according to one of the preceding claims, characterised thereby, that the master-slave flip-flop is a D-flip-flop, an RS-flip-flop or a JK-flip-flop.

4

## Revendications

1. Dispositif pour générer quatre horloges mutuellement décalées de $\pi/2$ de la moitié de la fréquence, caractérisé en ce qu'il comprend une seule bascule maître-esclave dont la partie maître et la partie esclave sont montées l'une derrière l'autre en une cascade, laquelle est complétée en un anneau par un rétrocouplage, l'un des deux couplages, le rétrocouplage ou le couplage en cascade, étant réalisé de façon inversée en ce sens que, par exemple dans le premier cas, l'entrée (D) de la partie maître est reliée à la sortie inversée ($\overline{Q_S}$) de la partie esclave et/ou l'entrée inverseuse de la partie maître est reliée à la sortie de la partie esclave, l'autre couplage n'étant pas réalisé de façon inversée, de sorte que la sortie ($Q_M$) de la partie maître est reliée à l'entrée de la partie esclave et que la sortie inversée ($\overline{Q_M}$) de la partie maître est reliée à l'entrée inverseuse de la partie esclave, et que les sorties ($Q_M$, $Q_S$) ainsi que les sorties inversées ($\overline{Q_M}$, $\overline{Q_S}$) des deux parties de la bascule fournissent les horloges mutuellement décalées de $\pi/2$ de la moitié de la fréquence.

2. Dispositif selon la revendication 1, caractérisé par son application dans un démultiplexeur 1:4 à un ou deux étages pour débits binaires élevés.

3. Dispositif selon la revendication 1 ou 2, caractérisé par son application dans un multiplexeur 4:1 à un ou deux étages.

4. Dispositif pour générer n horloges mutuellement décalées de $2\pi/n$ dans un système numérique de télécommunication, dans lequel des flux binaires correspondant au carré de n sont rassemblés côté émetteur au moyen de multiplexeurs à large bande, par multiplexage dans le temps, en un signal de données multiplexé, lequel est transmis puis décomposé de nouveau, au même débit binaire, côté réception, au moyen de démultiplexeurs à large bande, les multiplexeurs à large bande et les démultiplexeurs à large bande étant commandés par les n horloges, présentant chacune une fréquence d'horloge correspondant au débit binaire d'un des n flux binaires, la génération des horloges étant assurée par un ou plusieurs diviseurs 2:1 disposés en étages, caractérisé en ce qu'au moins un diviseur 2:1 est constitué par une seule bascule maître-esclave dont la partie maître et la partie esclave sont montées l'une derrière l'autre en une cascade, laquelle est complétée en un anneau par un rétrocouplage, l'un des deux couplages, le rétrocouplage ou le couplage en cascade, étant réalisé de façon inversée en ce sens que, par exemple dans le premier cas, l'entrée (D) de la partie maître est reliée à la sortie inversée ($\overline{Q_S}$) de la partie esclave et/ou l'entrée inverseuse de la partie maître est reliée à la sortie de la partie esclave, l'autre couplage n'étant pas réalisé de façon inversée, de sorte que la sortie ($Q_M$) de la partie maître est reliée à l'entrée de la partie esclave et que la sortie inversée ($\overline{Q_M}$) de la partie maître est reliée à l'entrée inverseuse de la partie esclave, et que les sorties ($Q_M$, $Q_S$) ainsi que les sorties inversées ($\overline{Q_M}$, $\overline{Q_S}$) des deux parties de la bascule fournissent les horloges mutuellement décalées de $\pi/2$ de la moitié de la fréquence (C1, $\overline{C1}$, C2, $\overline{C2}$).

5. Dispositif selon une des revendications précédentes, caractérisé en ce que la bascule maître-esclave est une bascule D, une bascule RS ou une bascule JK.

FIG. 1

FIG.2a

FIG.2b

FIG. 2c

FIG.2d

FIG. 2e

FIG. 3

FIG. 4a

FIG. 4b

FIG. 4c

$$1/f_T \hat{=} \frac{\pi}{2}$$

FIG. 5

FIG. 6a

FIG. 6b

FIG. 6c

Fig. 7

CHIP

Fig. 2

EP 0 226 754 B1